# EUROPÄISCHE PATENTANMELDUNG

(11) **EP 1 701 600 A1**
(43) Veröffentlichungstag der Anmeldung: **13.09.2006**
(21) Anmeldenummer: 06004082.1
(22) Anmeldetag: 01.03.2006
(51) Int. Cl.: H05K 3/40

(54) **Verfahren zur Kontaktierung von Leiterbahnen einer Leiterplatte**

(30) Priorität: 10.03.2005 DE 102005011545
(71) Anmelder: LPKF Laser & Electronics AG, 30827 Garbsen (DE)
(72) Erfinder: Meier, Dieter, Dr. rer. nat., 31542 Bad Nenndorf (DE)
(74) Vertreter: Scheffler, Jörg

(57) **Zusammenfassung**

Die Erfindung betrifft ein Verfahren zur Kontaktierung von in unterschiedlichen Ebenen angeordneten durch eine Isolatorschicht verbundene Leiterbahnen (1, 2) einer Leiterplatte (3) mittels einer die beiden Leiterbahnen (1, 2) elektrisch verbindenden leitfähigen Schicht (10). Um eine Vereinfachung des Verfahrens zu erreichen, wird zunächst jeweils eine außenseitige Abdeckung (5) auf die Leiterbahnen (1, 2) aufgebracht. Anschließend wird die Ausnehmung durch die Abdeckung (5) hindurch in die Leiterbahnen (1, 2) und die Isolatorschicht eingebracht. Eine die elektrisch leitfähige Schicht (10) bildende thixotrope Substanz (7) wird dann unter mechanischer Beanspruchung auf die Abdeckung (5) aufgebracht, so dass entlang der Innenwandfläche (9) der Ausnehmung eine elektrische Verbindung zwischen den Leiterbahnen (1, 2) entsteht. Die Abdeckungen (5) können dann entfernt werden. Hierdurch wird es erstmals möglich, die Durchkontaktierung auf die Leiterplatte (3) mit bereits vorhandenen Leiterbahnen (1, 2) flächig aufzutragen und dadurch den Steuerungsaufwand und die Prozessdauer wesentlich zu reduzieren.

## Beschreibung

Die Erfindung betrifft ein Verfahren zur Kontaktierung von in unterschiedlichen Ebenen angeordneten durch eine Isolatorschicht verbundenen Leiterbahnen einer Leiterplatte mittels einer die beiden Leiterbahnen elektrisch verbindenden leitfähigen Schicht, wobei zumindest abschnittsweise eine Abdeckung auf die Leiterbahnen zumindest einer Ebene aufgebracht wird, wobei anschließend die Ausnehmung durch die Abdeckung hindurch in die Isolatorschicht und zumindest eine Leiterbahn eingebracht sowie die elektrisch leitfähige Schicht auf die Abdeckung zumindest im Bereich der Ausnehmung aufgebracht wird, so dass entlang der Innenwandfläche der Ausnehmung eine elektrische Verbindung zwischen den Leiterbahnen entsteht.

Bei einem solchen Verfahren lassen sich nach dem Stand der Technik mit einer speziellen Leitpaste als leitfähige Schicht löt- und bestückbare Durchkontaktierungen auf doppelseitigen Leiterplatten herstellen, deren außenseitige Leiterbahnen mittels einer Isolatorschicht gegeneinander elektrisch isoliert sind. Der Durchmesser der die beiden Leiterplatten verbindenden, als Bohrungen ausgeführten Durchbrechungen beträgt dabei zwischen 0,5 mm und 1,4 mm.

Mittels einer Dosiernadel wird hierzu eine spezielle Leitpaste automatisiert in die Bohrungen injiziert und im darauf folgenden Arbeitsschritt abgesaugt. Durch das folgende Aushärten in einem Heißluftofen entstehen dauerhafte und vor allem bestückungsfähige Durchkontaktierungen. Die Steuerung des kompletten Durchkontaktierungsprozesses erfolgt automatisch mittels einer speziellen Software. Die Parameter für einen bestimmten Bohrungsdurchmesser sind in der Werkzeugbibliothek der Software hinterlegt. Kombiniert mit der individuellen Definition der Dispensparameter wird dieses Verfahren bereits für den Auftrag von Lötpaste, Kleber und Dichtungsmittel genutzt.

Als nachteilig erweist sich dabei der mit der Steuerung der Dosiernadel für die Leitpaste verbundene Aufwand. Insbesondere müssen also alle Positionen einzeln angefahren und die entsprechende Menge in Abhängigkeit von der Bohrlochbeschaffenheit zugeführt werden. Damit einher geht auch der erhebliche Zeitaufwand für die Durchführung des Verfahrens.

Weiterhin sind nach dem Stand der Technik auch bereits Verfahren zur mechanischen Verbindung der gegenüberliegenden Leiterbahn einer Leiterplatte bekannt. Hierzu werden beispielsweise Durchkontaktierungsnieten aus einer Kupferlegierung mit einem Durchmesser zwischen 0,3 mm und 1,4 mm eingesetzt. Die Durchkontaktierungsnieten werden manuell in das zuvor in die Leiterplatte eingebrachte Bohrloch eingesetzt und mit Hilfe eines Presswerkzeuges vernietet. Der geringe Aufwand und minimale Kosten zeichnen diese manuelle Lösung aus.

Als nachteilig erweist sich hierbei der geringe erreichbare Automatisierungsgrad des Verfahrens, so dass dieses Verfahren in der Praxis Sondereinsatzfällen vorbehalten ist.

Ein gattungsgemäßes Verfahren ist beispielsweise auch durch die GB 854 881 bekannt. Dabei wird zunächst eine Abdeckung aufgebracht und anschließend durch die Ausnehmung in der Abdeckung hindurch die elektrisch leitfähige Schicht auf die Abdeckung und in die Ausnehmung eingebracht, um so die elektrische Verbindung zwischen den Leiterbahnen zu erzeugen. Die leitfähige Schicht wird hierzu aufgesprüht.

Ferner beschreit die DE 34 20 966 A1 ein Siebdruckverfahren zur Herstellung von elektrischen Schaltkreisen, bei dem eine Paste mittels eines Rakels aufgebraucht wird. Auf der der Druckseite gegenüberliegenden Seite wird ein Unterdruck erzeugt, um so die Paste durch die Bohrungen hindurch zu saugen und dabei die Innenwandfläche zu benetzen. In ähnlicher Weise wird auch bei der DE 35 09 627 A1 zur Durchkontaktierung eine Lotpaste durch einen Lochkanal nacheinander von beiden Seiten hindurchgesaugt.

Unter Berücksichtigung der vorstehenden Nachteile liegt der Erfindung die Aufgabe zugrunde, ein vereinfachtes Verfahren zur Kontaktierung zu schaffen. Insbesondere soll dabei der zur Durchführung des Verfahrens erforderliche Steuerungsaufwand verringert werden.

Diese Aufgabe wird erfindungsgemäß mit einem Verfahren zur Kontaktierung gemäß den Merkmalen des Anspruchs 1 gelöst. Die Unteransprüche betreffen besonders zweckmäßige Ausgestaltungen der Erfindung.

Erfindungsgemäß ist also ein Verfahren zur Kontaktierung vorgesehen, bei dem die Schicht durch eine Substanz mit thixotropen Eigenschaften oder durch ein Bingham Medium gebildet und hierzu die elektrisch leitfähige Schicht unter mechanischer Beanspruchung auf die Abdeckung aufgebracht wird. Hierdurch wird durch die mechanische Beanspruchung, beispielsweise durch einen Stempel oder Einwirkung von Ultraschall, ausgehend von dem festen bzw. verformbaren Zustand ein flüssiger Zustand erreicht. Weil auf die in die Aussparung eingebrachte Substanz nach Beendigung des Vorganges keine Beanspruchung mehr wirkt, verfestigt sich die Substanz in der Aussparung wieder, so dass ein unerwünschtes Ablaufen bzw. Abgleiten und damit eine Unterbrechung der gewünschten Durchkontaktierung vermieden wird. Hierdurch wird es erstmals möglich, die Durchkontaktierung auf eine Leiterplatte mit bereits vorhandenen Leiterbahnen durch flächigen Auftrag der die leitfähige Schicht bildenden Substanz zu erreichen und dadurch den Steuerungsaufwand wesentlich zu reduzieren. Hierzu wird also zunächst eine die Leiterbahn schützende Abdeckung vorübergehend aufgebracht, durch die hindurch die Aussparung als Bohrung in die Leiterplatte derart eingebracht wird, dass die beiden Leiterbahnen durch die Bohrung hindurch verbunden werden können. Die Schicht wird dann flächig aufgetragen, dringt in die Aussparung ein und haftet an der Innenwandfläche der Aussparung zuverlässig an, so dass in diesem Bereich eine Durchkontaktierung der Leiterbahnen paralleler Ebenen realisiert wird. Die Abdeckungen werden anschließend entfernt.

Hierzu werden gemäß einer vorteilhaften Abwandlung der Erfindung die Parameter der Beanspruchung derart eingestellt, dass vorübergehend ein erster Zustand mit einer geringen Viskosität, also dünnflüssiger Zustand der Substanz mit wasserähnlichen Eigenschaften erreicht wird und die Substanz in diesem Zustand in die Ausnehmungen fließt. Anschließend erstarrt die Substanz bei nachlassender Beanspruchung, oder es stellt sich ein zweiter Zustand hoher Viskosität ein, so dass die Substanz an der Innenwandfläche der Ausnehmung optimal haftet. Hierdurch wird also durch das Aufbringen der beispielsweise Silber enthaltenden Schicht unter der Beanspruchung eine Verflüssigung erreicht, die es ermöglicht, dass die Schicht selbst in feinste Ausnehmungen zuverlässig eindringt und die Innenwandfläche bedeckt. Erfindungsgemäß können dabei sowohl Ausnehmungen in Form von Sacklöchern, also auch Durchgangslöchern, zur Durchkontaktierung zuverlässig genutzt werden, weil durch die thixotropen Eigenschaft bei nachlassender mechanischer Beanspruchung die Viskosität sprungartig ansteigt und dadurch das Abfließen der Substanz nach unten ausgeschlossen wird.

Die Eigenschaften der Substanz, insbesondere hinsichtlich der gewünschten Viskosität, werden hierzu entsprechend der Abmessungen der Ausnehmung bestimmt, um so eine gleich bleibende Schichtstärke auf der Innenwandfläche der Aussparung sicherzustellen. Ebenso kann ein an die thixotropen Eigenschaften der Substanz angepasstes Verhältnis der Ausnehmungen zu der Materialstärke der Leiterplatte vorgesehen werden.

Die Beanspruchung kann durch einen auf die Leiterplatte wirkenden Überdruck erzeugt werden. Eine besonders zweckmäßige Weiterbildung des Verfahrens wird hingegen dadurch erreicht, dass auf einer der Schicht abgewandten Seite ein Unterdruck in der Aussparung erzeugt wird. Hierdurch werden nicht nur überflüssige Mengen der Substanz zuverlässig abgezogen, so dass sich unerwünschte Materialaufhäufungen vermeiden lassen, sondern zugleich auch die Zuverlässigkeit der Benetzung der Innenwandfläche wesentlich erhöht und die Prozessdauer verkürzt.

Die Schicht kann nahezu beliebig aufgetragen werden. Beispielsweise könnte die flüssige Substanz aus einem Druckbehälter auf die Abdeckung aufgesprüht werden. Besonders einfach ist es hingegen, wenn die Schicht durch Rakeln aufgebracht wird. Die Substanz kann dadurch in einfacher Weise, beispielsweise auch ortsaufgelöst, aufgebracht werden und verflüssigt sich erst unter der mechanischen Beanspruchung des Rakels. Die erforderliche Menge der Substanz kann dadurch problemlos der gewünschten Position auf der Abdeckung zugeführt werden, so dass nicht benötigte Mengen entfernt oder einer weiteren Verwendung zugeführt werden können.

Die Aussparung kann als ein Sackloch durch die erste Leiterbahn und die Leiterplatte hindurch bis zur Oberfläche der zweiten Leiterbahn reichen. In gleicher Weise kann bei Leiterplatten mit mehr als zwei in verschiedenen Ebenen angeordneten, durch jeweils eine Isolatorschicht verbundenen Leiterbahnen die Ausnehmung zur Kontaktierung von zumindest zwei Leiterbahnen ebenfalls als ein Sackloch realisiert werden. Demgegenüber wird gemäß einer weiteren besonders zweckmäßigen Abwandlung die Aussparung als eine Durchbrechung der Leiterplatte ausgeführt, um so das Einbringen der Substanz von beiden Seiten in die Durchbrechung und damit eine optimierte Kontaktierung realisieren zu können. Hierzu wird auf beide Leiterbahnen jeweils eine Abdeckung aufgebracht.

Dabei erweist es sich als besonders sinnvoll, wenn die Leiterplatte aus einer ersten horizontalen Position, in welcher die erste Abdeckung nach oben weist, in eine zweite, umgekehrte Position, in welcher die zweite Abdeckung nach oben weist, gebracht und auf diese zweite Abdeckung eine weitere Schicht aufgetragen wird. Hierdurch wird eine zuverlässige Benetzung der Innenwandfläche der Durchbrechung auch bei einer großen Materialstärke der Leiterplatte realisiert. Die Substanz haftet dabei derart an der Innenwandfläche an, dass ein mittlerer Bereich ausgespart und daher ein Unterdruck auch beim Aufbringen der zweiten Schicht durch die Durchbrechung hindurch auf die Substanz wirkt.

Die Abdeckung kann in einer nahezu beliebigen Form aufgebracht werden, die eine spätere rückstandsfreie Entfernung der Abdeckung gestattet. Besonders praxisgerecht ist hingegen eine Abwandlung, bei der die Abdeckung eine Folie oder Beschichtung aufweist. Hierzu dient eine handelsübliche, insbesondere selbstklebende Folie, die sowohl manuell als auch automatisiert auf die Leiterbahn aufgebracht werden kann. Dadurch ist zugleich eine einheitliche Materialstärke sichergestellt. Zudem gestattet die Folie oder Beschichtung eine einfache visuelle Kontrolle der vollständigen Abdeckung. Die Folie kann ferner auch transparent oder transmissiv ausgeführt sein, um die Positionierung des Werkzeuges relativ zu der Ausnehmung zu vereinfachen.

Die thixotropen Eigenschaften der Metallisierungspaste ermöglichen ein sauberes und rückstandsfreies Entfernen der Folie. Dabei wird durch den Abziehprozess der Folie, der möglichst im Winkel von 45 Grad erfolgen sollte, erreicht, dass sich die Metallisierungspaste nach dem Trennvorgang rückstandsfrei und ohne Bildung von Verunreinigungen (Nasenbildung) zum Leiterplattenmaterial zieht und durch die mittels eingestellter Folienstärke das erforderliche Pastenreservoir für eine sichere Ankontaktierung gegeben ist.

Die Erfindung ist dabei selbstverständlich nicht auf lediglich zwei Leiterbahn-Ebenen beschränkt, sondern ist auch bei Leiterplatten mit beliebig vielen Ebenen in vorteilhafter Weise anwendbar. Ferner ist die Zufuhr der Substanz in flüssiger Form mittels einer Dosiernadel realisierbar, wobei gegebenenfalls auch die Abdeckungen entfallen können.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt jeweils in einer die Verfahrensschritte darstellenden Prinzipskizze in
Fig.1 eine Leiterplatte mit zwei Leiterbahnen;
Fig.2 die Leiterplatte mit zwei jeweils eine Leiterbahn schützende Abdeckungen;
Fig.3 das Aufbringen der die Schicht bildenden Substanz auf die erste Abdeckung;
Fig.4 das Aufbringen der Substanz auf die zweite Abdeckung;
Fig.5 die Leiterplatte nach dem Entfernen der Abdeckungen.

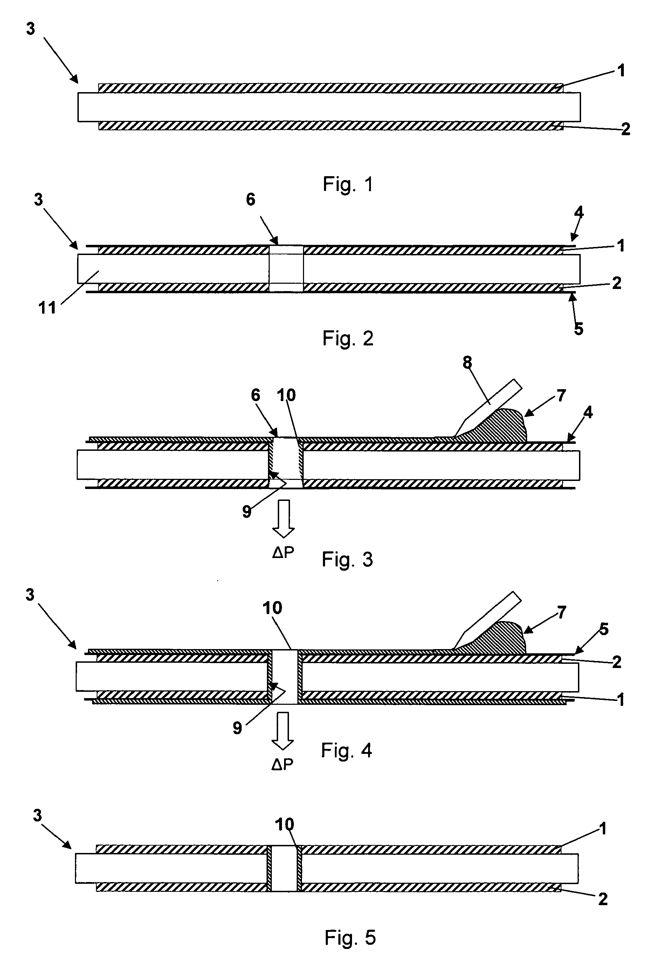

Die Figuren 1 bis 5 zeigen die einzelnen Verfahrensschritte des erfindungsgemäßen Verfahrens zur Kontaktierung von in zwei parallelen Ebenen angeordneten Leiterbahnen 1, 2 einer Leiterplatte 3. Ausgehend von der in Figur 1 gezeigten Leiterplatte 3 mit außenseitigen Leiterbahnen 1, 2 werden in einem ersten Schritt gemäß Figur 2 beide Leiterbahnen 1, 2 mit jeweils einer als Folie ausgeführten Abdeckung 4, 5 geschützt. Anschließend wird eine als Durchgangsbohrung ausgeführte Ausnehmung 6 durch die Leiterbahnen 1, 2 sowie eine diese isolierend verbindende Isolatorschicht 11 mittels eines nicht gezeigten Werkzeuges in die Leiterplatte 3 einschließlich der beiden Leiterbahnen 1, 2 und ihrer Abdeckungen 4, 5 eingebracht. Auf die so vorbereitete Leiterplatte 3 wird gemäß Figur 3 eine Substanz 7 mittels eines Rakels 8 auf die Abdeckung 4 aufgebracht, die unter der so einwirkenden mechanischen Beanspruchung ihren flüssigen Zustand einnimmt. Zusätzlich wirkt auf der gegenüberliegenden Seite der Ausnehmung 6 ein Unterdruck ΔP, welcher das Eindringen der Substanz 7 in die Ausnehmung 6 begünstigt. Hierdurch bildet die Substanz 7 an einer Innenwandfläche 9 der Ausnehmung 6 eine elektrisch leitfähige Schicht 10, die sich aufgrund der reduzierten mechanischen Beanspruchung innerhalb der Ausnehmung 6 verfestigt. Der Rakelprozess wird, wie aus Figur 4 ersichtlich, wiederholt, nachdem die Leiterplatte 3 zuvor gewendet wurde, so dass nunmehr die Substanz 7 auf die andere Abdeckung 5 aufgebracht wird. Die Innenwandfläche 9 wird dadurch vollflächig mit der die Schicht 10 bildenden Substanz 7 benetzt und die Kontaktierung der beiden Leiterbahnen 1, 2 somit zuverlässig gewährleistet. Nach dem Entfernen der beiden Abdeckungen 4, 5, ist in Figur 5 nunmehr eine zuverlässige Durchkontaktierung der beiden gegenüberliegenden Leiterbahnen 1, 2 der Leiterplatte 3 erreicht, wobei die elektrisch leitfähige Schicht 10 gegebenenfalls noch in einem nachfolgenden Verfahrensschritt durch thermische Energiezufuhr ausgehärtet werden kann.

## Patentansprüche

1. Verfahren zur Kontaktierung von in unterschiedlichen Ebenen angeordneten, durch eine Isolatorschicht verbundenen Leiterbahnen einer Leiterplatte mittels einer die beiden Leiterbahnen elektrisch verbindenden leitfähigen Schicht, wobei zumindest abschnittsweise eine Abdeckung auf die Leiterbahnen zumindest einer Ebene aufgebracht wird, wobei anschließend die Ausnehmung durch die Abdeckung hindurch in die Isolatorschicht und zumindest eine Leiterbahn eingebracht sowie die elektrisch leitfähige Schicht auf die Abdeckung zumindest im Bereich der Ausnehmung aufgebracht wird, so dass entlang der Innenwandfläche der Ausnehmung eine elektrische Verbindung zwischen den Leiterbahnen entsteht, **dadurch gekennzeichnet, dass** die Schicht durch eine Substanz mit thixotroper Eigenschaft oder durch ein Bingham Medium gebildet wird und hierzu die elektrisch leitfähige Schicht unter insbesondere mechanischer Beanspruchung auf die Abdeckung aufgebracht wird.

2. Verfahren nach Anspruch 1, **dadurch gekennzeichnet, dass** die Parameter der Beanspruchung derart eingestellt werden, dass vorübergehend ein Zustand geringer Viskosität der Substanz erreicht wird und die Substanz in diesem Zustand in die Ausnehmungen fließt.

3. Verfahren nach den Ansprüchen 1 oder 2, **dadurch gekennzeichnet, dass** die Substanz in dem ersten Zustand unter Beanspruchung in die Ausnehmung fließt und anschließend bei nachlassender Beanspruchung ein zweiter Zustand hoher Viskosität der Substanz eingestellt wird, in welchem die Substanz an der Innenwandfläche der Ausnehmung haftet.

4. Verfahren nach zumindest einem der vorhergehenden Ansprüche, **dadurch gekennzeichnet, dass** die Beanspruchung durch einen auf die Leiterplatte wirkenden Überdruck erzeugt wird.

5. Verfahren nach zumindest einem der vorhergehenden Ansprüche, **dadurch gekennzeichnet, dass** auf einer der Schicht abgewandten Seite ein Unterdruck in der Ausnehmung erzeugt wird.

6. Verfahren nach zumindest einem der vorhergehenden Ansprüche, **dadurch gekennzeichnet, dass** die Schicht durch Rakeln aufgebracht wird.

7. Verfahren nach zumindest einem der vorhergehenden Ansprüche, **dadurch gekennzeichnet, dass** die Ausnehmung als eine Durchbrechung der Leiterplatte ausgeführt wird.

8. Verfahren nach zumindest einem der vorhergehenden Ansprüche, **dadurch gekennzeichnet, dass** auf beide Leiterbahnen jeweils eine Abdeckung aufgebracht wird.

9. Verfahren nach zumindest einem der vorhergehenden Ansprüche, **dadurch gekennzeichnet, dass** die Leiterplatte aus einer ersten horizontalen Position, in welcher die erste Abdeckung nach oben weist, in eine zweite, umgekehrte Position, in welcher die zweite Abdeckung nach oben weist, gebracht und auf diese zweite Abdeckung eine weitere Schicht aufgetragen wird.

10. Verfahren nach zumindest einem der vorhergehenden Ansprüche, **dadurch gekennzeichnet, dass** die Abdeckung eine Folie oder Beschichtung aufweist.
